# FASCICULE DE BREVET EUROPEEN

(11) **EP 3 671 864 B1**
(45) Date de publication et mention de la délivrance du brevet: **26.10.2022**
(21) Numéro de dépôt: 19217691.5
(22) Date de dépôt: 18.12.2019
(51) Int. Cl.: H01L 31/0288, H01L 31/0687, H01L 31/0725, H01L 31/18, H01L 21/265, H01L 21/22, H01L 27/142, H01L 29/88

(54) **PROCEDE DE FABRICATION D'UNE JONCTION A EFFET TUNNEL INTER-BANDES**
VERFAHREN ZUR HERSTELLUNG EINES ÜBERGANGS MIT INTERBAND-TUNNELEFFEKT
PROCESS FOR FABRICATION A JUNCTION WITH INTERBAND TUNNEL EFFECT

(30) Priorité: 20.12.2018 FR 1873568
(43) Date de publication de la demande: 24.06.2020
(73) Titulaire: Commissariat à l'énergie atomique et aux énergies alternatives, 75015 Paris (FR)
(72) Inventeur: BELLANGER, Pierre, 38054 GRENOBLE cedex 09 (FR); DESRUES, Thibaut, 38054 GRENOBLE cedex 09 (FR); LANTERNE, Adeline, 38054 GRENOBLE cedex 09 (FR)
(74) Mandataire: INNOV-GROUP

(56) Documents cités:
- US-A1- 2012 322 192
- BELLANGER PIERRE ET AL: "Silicon Tunnel Junctions Produced by Ion Implantation and Diffusion Processes for Tandem Solar Cells", IEEE JOURNAL OF PHOTOVOLTAICS, I E E E, US, vol. 8, no. 6, 18 septembre 2018 (2018-09-18), pages 1436-1442, XP011703398, ISSN: 2156-3381, DOI: 10.1109/JPHOTOV.2018.2864632 [extrait le 2018-10-26]
- ALAIN FAVE ET AL: "Fabrication of Si tunnel diodes for c-Si based tandem solar cells using proximity rapid thermal diffusion", ENERGY PROCEDIA, vol. 124, 1 septembre 2017 (2017-09-01), pages 577-583, XP055646551, NL ISSN: 1876-6102, DOI: 10.1016/j.egypro.2017.09.281
- RAY ASHOK ET AL: "Optimization of a plasma immersion ion implantation process for shallow junctions in silicon", JOURNAL OF VACUUM SCIENCE AND TECHNOLOGY: PART A, AVS /AIP, MELVILLE, NY., US, vol. 32, no. 6, 8 octobre 2014 (2014-10-08), pages 061302-1-061302-9, XP012190917, ISSN: 0734-2101, DOI: 10.1116/1.4896756 [extrait le 1901-01-01]

## Description

### Domaine technique

L'invention se rapporte au domaine technique des jonctions à effet tunnel inter-bandes.

L'invention trouve notamment son application dans la fabrication de cellules photovoltaïques tandem, où la jonction à effet tunnel inter-bandes permet leur connexion en série, ou encore dans la fabrication de différents dispositifs de microélectronique tels que des générateurs ou des amplificateurs.

### Etat de la technique antérieure

Un procédé de fabrication d'une jonction à effet tunnel inter-bandes connu de l'état de la technique, notamment du document P. Bellanger et al., « Silicon Tunnel Junctions produced by Ion Implantation and Diffusion Processesfor Tandem Solar Cells », IEEE Journal of Photovoltaics, vol.8, n°6, septembre 2018, comporte les étapes :
a') prévoir un substrat, réalisé en silicium cristallin, et présentant une première surface ;
b') implanter des premiers dopants, d'un premier type de conductivité, dans le substrat à travers la première surface ; l'étape b') étant exécutée par une technique d'implantation par faisceau d'ions, de manière à obtenir un premier profil de concentration des premiers dopants dans le substrat ;
c') implanter des seconds dopants, d'un second type de conductivité différent du premier type de conductivité, dans le substrat à travers la première surface ; l'étape c') étant exécutée par une technique d'implantation par faisceaux d'ions, de manière à obtenir un second profil de concentration des seconds dopants dans le substrat ;
d') appliquer un traitement thermique au substrat, adapté pour activer électriquement les premiers et seconds dopants.

Les étapes b') et c') sont exécutées avec des énergies d'implantation adaptées de sorte que les premier et second profils présentent des pics de concentration décalés dans la profondeur du substrat.

Un tel procédé de l'état de la technique n'est pas entièrement satisfaisant dans la mesure où les implantations par faisceaux d'ions des étapes b') et c') :
- ne sont pas compatibles en termes de coût et de cadence avec une chaîne de production de cellules photovoltaïques,
- sont limitées pour réaliser des implantations à très faible énergie, ce qui conduit à l'obtention de jonctions à effet tunnel profondes induisant des recombinaisons (de type Auger) de porteurs de charge minoritaires diminuant la qualité électrique des jonctions à effet tunnel.

### Exposé de l'invention

L'invention, définie par l'objet de la revendication 1, vise à remédier en tout ou partie aux inconvénients précités. A cet effet, l'invention a pour objet un procédé de fabrication d'une jonction à effet tunnel inter-bandes, comportant les étapes :
a) prévoir un substrat, réalisé en silicium cristallin, et présentant une première surface ;
b) implanter des premiers dopants, d'un premier type de conductivité, dans le substrat à travers la première surface ; l'étape b) étant exécutée par une technique d'implantation ionique par immersion plasma, de manière à obtenir un premier profil de concentration des premiers dopants dans le substrat ;
c) implanter des seconds dopants, d'un second type de conductivité différent du premier type de conductivité, dans le substrat à travers la première surface ; l'étape c) étant exécutée par une technique d'implantation ionique par immersion plasma, de manière à obtenir un second profil de concentration des seconds dopants dans le substrat ;
d) appliquer un traitement thermique au substrat, adapté pour que :
   - le premier profil soit modifié et s'étende sur une première épaisseur, et que le second profil soit modifié et s'étende sur une seconde épaisseur strictement supérieure à la première épaisseur ;
   - les premiers et seconds dopants soient activés électriquement ;
   - les seconds dopants possèdent une vitesse de diffusion dans le substrat supérieure à celle des premiers dopants, jusqu'à obtenir :
      une première zone du substrat avec une différence de concentration entre les premiers dopants et les seconds dopants supérieure ou égale à une valeur seuil prédéterminée,
      une seconde zone du substrat avec une différence de concentration entre les seconds dopants et les premiers dopants supérieure ou égale à la valeur seuil prédéterminée.

Plus précisément, le traitement thermique est appliqué au substrat lors de l'étape d) selon un budget thermique ; les implantations des étapes b) et c) et le budget thermique du traitement thermique de l'étape d) sont adaptés pour que :
- le premier profil soit modifié et s'étende sur une première épaisseur, et que le second profil soit modifié et s'étende sur une seconde épaisseur strictement supérieure à la première épaisseur. Le budget thermique du traitement thermique de l'étape d) est adapté pour que:
- les premiers et seconds dopants soient activés électriquement ;
- les seconds dopants possèdent une vitesse de diffusion dans le substrat supérieure à celle des premiers dopants, jusqu'à obtenir :
   une première zone du substrat présentant une différence de concentration entre les premiers dopants et les seconds dopants supérieure ou égale à 5×10¹⁹ at. cm⁻³,
   une seconde zone du substrat présentant une différence de concentration entre les seconds dopants et les premiers dopants supérieure ou égale à 5×10¹⁹ at. cm⁻³.

La différence de concentration entre les premiers dopants et les seconds dopants dans la première zone du substrat, ainsi que la différence de concentration entre les seconds dopants et les premiers dopants dans la seconde zone du substrat, sont de préférence choisies de sorte que la jonction à effet tunnel inter-bandes possède une zone de charge d'espace présentant une épaisseur comprise entre 3 nm et 6 nm, de préférence inférieure ou égale à 4 nm. En d'autres termes, la différence de concentration entre les premiers dopants et les seconds dopants dans la première zone du substrat, ainsi que la différence de concentration entre les seconds dopants et les premiers dopants dans la seconde zone du substrat, sont de préférence suffisamment importantes (supérieures ou égales à 5×10¹⁹ at. cm⁻³, préférentiellement supérieures ou égales à 10²⁰ at. cm⁻³, plus préférentiellement supérieures ou égales à 10²¹ at. cm⁻³) de sorte que la jonction à effet tunnel inter-bandes possède une zone de charge d'espace présentant une épaisseur comprise entre 3 nm et 6 nm, de préférence inférieure ou égale à 4 nm.

Ainsi, un tel procédé selon l'invention permet, grâce à l'implantation ionique par immersion plasma des étapes b) et c), d'implanter des dopants avec une cadence compatible avec la production de cellules photovoltaïques (au moins supérieur à 1500 substrats par heure) et d'implanter des dopants moins en profondeur et donc plus proches de la première surface du substrat que l'implantation par faisceaux d'ions, ce qui permet d'envisager des jonctions à effet tunnel plus fines et donc de meilleure qualité électrique. L'implantation ionique par immersion plasma est également moins coûteuse que la technique d'implantation par faisceaux d'ions, notamment en termes de dépenses d'investissement, de maintenance, d'espace au sol etc.

L'utilisation de l'implantation ionique par immersion plasma conduit, à l'issue des étapes b) et c), à une superposition des pics de concentration des premiers et seconds dopants à la première surface du substrat. L'étape d) permet ainsi de diffuser suffisamment, dans la profondeur du substrat, les seconds dopants de manière à obtenir :
une première zone du substrat présentant une différence de concentration entre les premiers dopants et les seconds dopants supérieure ou égale à une valeur seuil prédéterminée,
une seconde zone du substrat présentant une différence de concentration entre les seconds dopants et les premiers dopants supérieure ou égale à la valeur seuil prédéterminée, et obtenir par là-même une jonction à effet tunnel inter-bandes.

Le fait que le second profil modifié s'étende sur une seconde épaisseur, strictement supérieure à la première épaisseur, permet de définir à l'issue de l'étape d) et de la compensation des premier et second profils modifiés :
- une première zone du substrat -dite jonction courte ou jonction fine- majoritairement dopée du premier type de conductivité par les premiers dopants (porteurs libres) ;
- une seconde zone du substrat -dite jonction longue ou jonction profondemajoritairement dopée du second type de conductivité par les seconds dopants (porteurs libres).

Un autre avantage procuré par l'étape d) est de corriger les défauts cristallins provoqués par les implantations ioniques lors des étapes b) et c).

### Définitions

- Par « effet tunnel inter-bandes », on entend le mécanisme de conduction électrique à travers la jonction, se produisant d'une bande à une autre (e.g. bande de conduction / bande de valence) de part et d'autre de la jonction, contrairement à l'effet tunnel intra-bande qui se produit au sein d'une même bande.
- Par « substrat », on entend un support physique autoporté, par exemple une tranche («*wafer*» en langue anglaise) découpée dans un lingot monocristallin de silicium.
- Par « cristallin », on entend la forme multicristalline ou la forme monocristalline du silicium, excluant donc le silicium amorphe.
- Par « profil», on entend la répartition des premiers et seconds dopants suivant une direction transverse, correspondant à la normale à la première surface du substrat.
- Par « épaisseur », on entend la dimension suivant la normale à la première surface du substrat.
- Par « activés électriquement », on entend le passage des premiers et seconds dopants en site substitutionnel.
- Par « budget thermique », on entend le choix d'une valeur de température du traitement thermique et le choix d'une valeur de durée du traitement thermique.

Le procédé selon l'invention peut comporter une ou plusieurs des caractéristiques suivantes.

Selon une caractéristique de l'invention, la valeur seuil est prédéterminée de sorte que la jonction à effet tunnel inter-bandes possède une zone de charge d'espace présentant une épaisseur comprise entre 3 nm et 6 nm, de préférence inférieure ou égale à 4 nm.

Ainsi, un avantage procuré est de faciliter le passage des porteurs de charge (porteurs libres) entre la première zone du substrat -dite jonction courte ou jonction finemajoritairement dopée du premier type de conductivité par les premiers dopants, et la seconde zone du substrat -dite jonction longue ou jonction profonde- majoritairement dopée du second type de conductivité par les seconds dopants.

Selon une caractéristique de l'invention, la valeur seuil prédéterminée est égale à 5×10¹⁹ at. cm⁻³.
« at. » désigne le nombre d'atomes.
« x » désigne l'opérateur de la multiplication.

Ainsi, il est possible d'obtenir une zone de charge d'espace fine (de l'ordre de 4 nm à 5 nm).

Selon une caractéristique de l'invention, la seconde épaisseur est inférieure ou égale à 500 nm, de préférence inférieure ou égale à 200 nm.

Ainsi, un avantage procuré est de réduire la recombinaison des porteurs minoritaires (i.e. les électrons lorsque les premiers dopants sont de type p, ou les trous lorsque les premiers dopants sont de type n) par rapport à une jonction à effet tunnel plus profonde.

Selon une caractéristique de l'invention, la technique d'implantation ionique par immersion plasma est exécutée lors de l'étape b) avec :
- une dose de premiers dopants adaptée pour que le premier profil modifié présente une zone avec des valeurs de concentrations supérieures ou égales à la valeur seuil prédéterminée à l'issue de l'étape d) ;
- une tension de polarisation du plasma adaptée au traitement thermique de l'étape d) pour que le premier profil modifié s'étende sur la première épaisseur à l'issue de l'étape d).

Ainsi, la tension de polarisation du plasma permet, en conjonction avec le traitement thermique de l'étape d), de contrôler l'épaisseur (i.e. la profondeur) de la première zone du substrat -dite jonction courte ou jonction fine- majoritairement dopée du premier type de conductivité par les premiers dopants.

Plus précisément, la technique d'implantation ionique par immersion plasma est exécutée lors de l'étape b) avec :
- une dose de premiers dopants adaptée au budget thermique du traitement thermique de l'étape d) pour que le premier profil modifié présente une zone avec des valeurs de concentrations supérieures ou égales à 5×10¹⁹ at. cm⁻³ à l'issue de l'étape d) ;
- une tension de polarisation du plasma adaptée au budget thermique du traitement thermique de l'étape d) pour que le premier profil modifié s'étende sur la première épaisseur à l'issue de l'étape d).

Selon une caractéristique de l'invention, la technique d'implantation ionique par immersion plasma est exécutée lors de l'étape c) avec :
- une dose de seconds dopants adaptée pour que le second profil modifié présente une zone avec des valeurs de concentrations supérieures ou égales à la valeur seuil prédéterminée à l'issue de l'étape d) ;
- une tension de polarisation du plasma adaptée au traitement thermique de l'étape d) pour que le second profil modifié s'étende sur la seconde épaisseur à l'issue de l'étape d).

Ainsi, la tension de polarisation du plasma permet, en conjonction avec le traitement thermique de l'étape d), de contrôler l'épaisseur (i.e. la profondeur) de la seconde zone du substrat -dite jonction longue ou jonction profonde- majoritairement dopée du second type de conductivité par les seconds dopants.

Plus précisément, la technique d'implantation ionique par immersion plasma est exécutée lors de l'étape c) avec :
- une dose de seconds dopants adaptée au budget thermique du traitement thermique de l'étape d) pour que le second profil modifié présente une zone avec des valeurs de concentrations supérieures ou égales à 5×10¹⁹ at. cm⁻³ à l'issue de l'étape d) ;
- une tension de polarisation du plasma adaptée au budget thermique du traitement thermique de l'étape d) pour que le second profil modifié s'étende sur la seconde épaisseur à l'issue de l'étape d).

Selon une caractéristique de l'invention, le traitement thermique est appliqué lors de l'étape d) sous une atmosphère oxydante ou sous une atmosphère comportant majoritairement du H₂.

Ainsi, un avantage procuré est de pouvoir accélérer la diffusion des seconds dopants, selon leur nature et celle des premiers dopants, notamment par des phénomènes d'accélération de la diffusion (TED pour « *Transient Enhanced Diffusion* » en langue anglaise), lorsque les premiers et seconds dopants possèdent des coefficients de diffusion similaires pour une valeur donnée de température du traitement thermique de l'étape d).

Selon une caractéristique de l'invention, le traitement thermique appliqué lors de l'étape d) est un recuit thermique comportant un cycle de chauffage comprenant :
- une première phase de montée graduelle d'une température de chauffage jusqu'à atteindre une valeur plateau ;
- une deuxième phase où la température de chauffage conserve la valeur plateau ;
- une troisième phase de refroidissement.

Selon une caractéristique de l'invention, le recuit thermique appliqué lors de l'étape d) est un recuit thermique rapide, la deuxième phase présentant une durée inférieure ou égale à 300 secondes, de préférence inférieure ou égale à 30 secondes.

Selon une caractéristique de l'invention, la première surface du substrat prévu lors de l'étape a) est revêtue d'une couche de passivation ; les étapes b) et c) étant exécutées de sorte que les premiers et seconds dopants sont implantés à travers la couche de passivation.

Ainsi, un avantage procuré est d'améliorer la qualité cristalline de la jonction à effet tunnel inter-bandes en implantant les premiers et seconds dopants à travers la couche de passivation. En outre, une telle couche de passivation peut permettre une diffusion des seconds dopants supérieure à celle des premiers dopants lors de l'étape d). Les premiers et seconds dopants peuvent être implantés lors des étapes b) et c) en tout ou partie dans la couche de passivation, une partie des premiers et seconds dopants pouvant être implantée dans le substrat, en dehors de la couche de passivation.

Selon une caractéristique de l'invention, le substrat prévu lors de l'étape a) est dopé du premier type de conductivité.

Ainsi, en plus de la jonction à effet tunnel, une jonction p/n ou une jonction n/p est créée en vue de la formation d'une cellule photovoltaïque.

### Brève description des dessins

D'autres caractéristiques et avantages apparaîtront dans l'exposé détaillé de différents modes de réalisation de l'invention, l'exposé étant assorti d'exemples et de références aux dessins joints.
Figures la à 1d sont des vues schématiques en coupe illustrant des étapes d'un procédé selon l'invention.
Figure 2 est une vue schématique en coupe d'un substrat revêtu d'une couche de passivation.
Figure 3 est un graphique représentant en ordonnées les premier et second profils de concentration (en nombre d'atomes par cm³) des premiers et seconds dopants qui sont implantés dans le substrat avant l'étape d), et en abscisses l'épaisseur (ou la profondeur) en nm desdits profils.
Figure 4 est un graphique représentant en ordonnées les premier et second profils de concentration (en nombre d'atomes par cm³) des premiers et seconds dopants dans le substrat qui sont modifiés après l'étape d), et en abscisses l'épaisseur (ou la profondeur) en nm desdits profils modifiés.
Figure 5 est un graphique représentant en ordonnées la concentration (en nombre d'atomes par cm³) des porteurs libres dans le substrat après l'étape d) et la compensation des premier et second profils modifiés, et en abscisses l'épaisseur (ou la profondeur) en nm.

Il est à noter que les dessins décrits ci-avant sont schématiques et ne sont pas à l'échelle par souci de lisibilité. Les coupes sont effectuées selon la normale à la première surface du substrat.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'une jonction à effet tunnel inter-bandes, comportant les étapes :
a) prévoir un substrat 1, réalisé en silicium cristallin, et présentant une première surface 10 ;
b) implanter des premiers dopants 2, d'un premier type de conductivité, dans le substrat 1 à travers la première surface 10 ; l'étape b) étant exécutée par une technique d'implantation ionique par immersion plasma 20, de manière à obtenir un premier profil P₁ de concentration des premiers dopants 2 dans le substrat 1 ;
c) implanter des seconds dopants 3, d'un second type de conductivité différent du premier type de conductivité, dans le substrat 1 à travers la première surface 10 ; l'étape c) étant exécutée par une technique d'implantation ionique par immersion plasma 30, de manière à obtenir un second profil P₂ de concentration des seconds dopants 3 dans le substrat 1 ;
d) appliquer un traitement thermique au substrat 1, adapté pour que :
   - le premier profil P₁ soit modifié et s'étende sur une première épaisseur e₁, et que le second profil P₂ soit modifié et s'étende sur une seconde épaisseur e₂ strictement supérieure à la première épaisseur e₁ ;
   - les premiers et seconds dopants 2, 3 sont activés électriquement ;
   - les seconds dopants 3 possèdent une vitesse de diffusion dans le substrat 1 supérieure à celle des premiers dopants 2, jusqu'à obtenir :
      une première zone 200 du substrat 1 présentant une différence de concentration entre les premiers dopants 2 et les seconds dopants 3 supérieure ou égale à une valeur seuil Cₘᵢₙ prédéterminée,
      une seconde zone 300 du substrat 1 présentant une différence de concentration entre les seconds dopants 3 et les premiers dopants 2 supérieure ou égale à la valeur seuil Cₘᵢₙ prédéterminée.

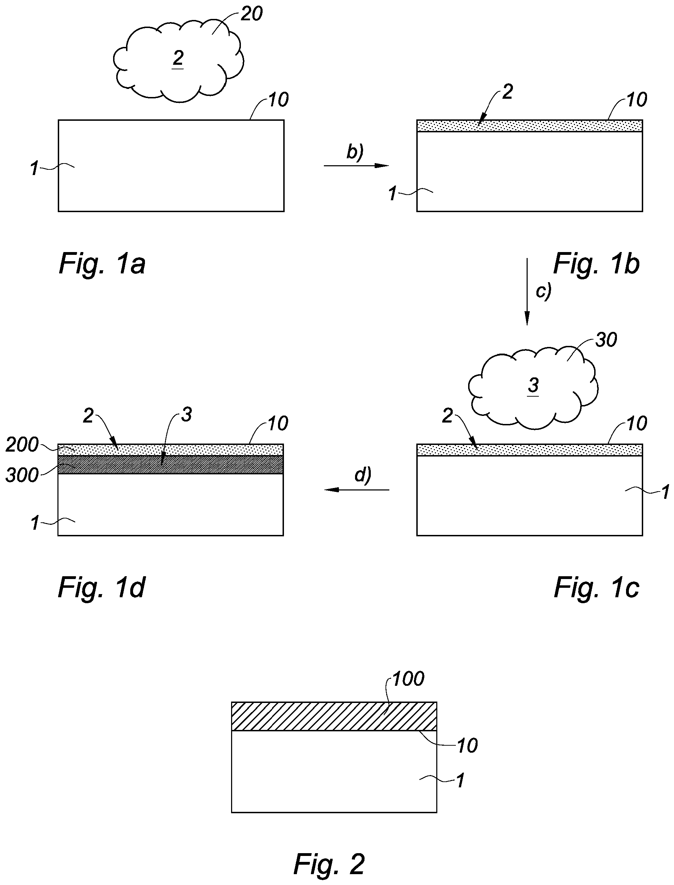

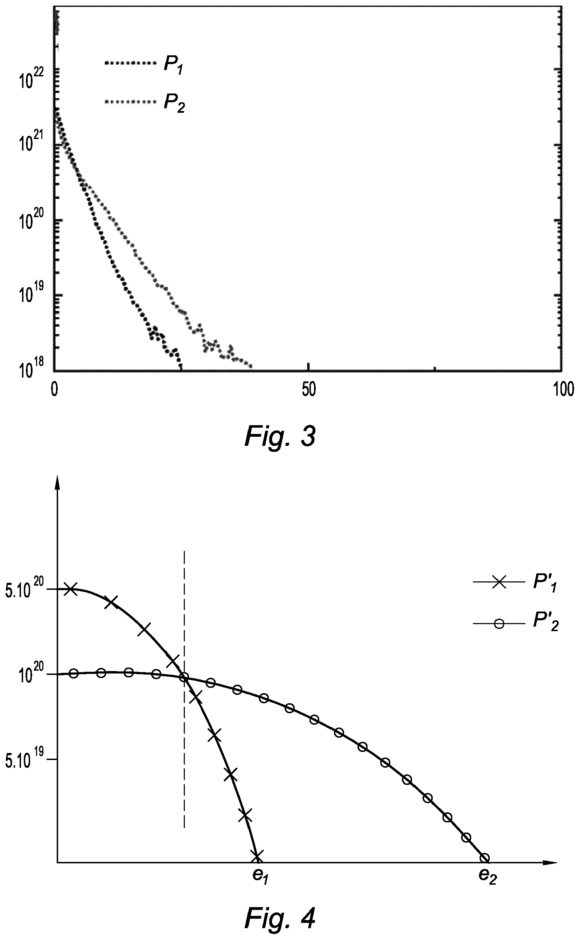

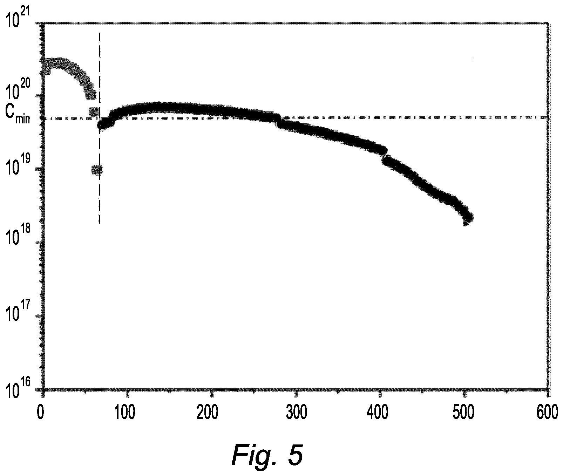

L'étape a) est illustrée à la figure la. L'étape b) est illustrée aux figures la et 1b. Le premier profil P₁ obtenu à l'issue de l'étape b) est illustré à la figure 3. L'étape c) est illustrée à la figure 1c. Le second profil P₂ obtenu à l'issue de l'étape c) est illustré à la figure 3. Les premier et second profils modifiés P'₁, P'₂ obtenus à l'issue de l'étape d) sont illustrés à la figure 4. La concentration des porteurs libres obtenue à l'issue de l'étape d) et de la compensation des premier et second profils modifiés P'₁, P'₂ est illustrée à la figure 5.

Plus précisément, le traitement thermique est appliqué au substrat 1 lors de l'étape d) selon un budget thermique adapté pour que :
- le premier profil P₁ soit modifié et s'étende sur une première épaisseur e₁, et que le second profil P₂ soit modifié et s'étende sur une seconde épaisseur e₂ strictement supérieure à la première épaisseur e₁ ;
- les premiers et seconds dopants 2, 3 soient activés électriquement ;
- les seconds dopants 3 possèdent une vitesse de diffusion dans le substrat 1 supérieure à celle des premiers dopants 2, jusqu'à obtenir :
   une première zone 200 du substrat 1 présentant une différence de concentration entre les premiers dopants 2 et les seconds dopants 3 supérieure ou égale à 5×10¹⁹ at. cm⁻³,
   une seconde zone 300 du substrat 1 présentant une différence de concentration entre les seconds dopants 3 et les premiers dopants 2 supérieure ou égale à 5×10¹⁹ at. cm⁻³.

### Substrat prévu lors de l'étape a)

Le substrat 1 prévu lors de l'étape a) est avantageusement dopé du premier type de conductivité, c'est-à-dire du même type de conductivité que la zone 200 du substrat -dite jonction courte ou jonction fine- majoritairement dopée par les premiers dopants 2.

Le substrat 1 peut être réalisé en silicium monocristallin ou en silicium multicristallin.

A titre d'exemple non limitatif, le substrat 1 peut présenter une épaisseur comprise entre 100 µm et 600 µm.

Comme illustré à la figure 2, la première surface 10 du substrat 1 prévu lors de l'étape a) est avantageusement revêtue d'une couche de passivation 100. A titre d'exemples non limitatifs, la couche de passivation 100 peut être réalisée dans un matériau sélectionné parmi SiN, SiOₓ, un oxyde transparent conducteur, une couche de silicium amorphe, une couche de polysilicium. Il est à noter que la couche de silicium amorphe se transforme en polysilicium après l'étape d). La couche de passivation 100 peut être active (électriquement conductrice) lorsqu'il s'agit d'une couche de silicium amorphe ou d'une couche de polysilicium. La couche de passivation 100 présente préférentiellement une épaisseur comprise entre 10 nm et 200 nm, plus préférentiellement comprise entre 20 nm et 100 nm. A l'issue de l'étape d), dans le cas de la fabrication de cellules photovoltaïques tandem, la couche de passivation 100 peut être gravée en tout ou partie (e.g. par laser ou chimiquement) pour autoriser une conduction électrique via la jonction à effet tunnel inter-bandes. Toutefois, lorsque la couche de passivation 100 est électriquement conductrice, celle-ci peut être conservée.

### Valeur seuil

La valeur seuil Cₘᵢₙ est avantageusement prédéterminée de sorte que la jonction à effet tunnel inter-bandes possède une zone de charge d'espace présentant une épaisseur comprise entre 3 nm et 6 nm, de préférence inférieure ou égale à 4 nm.

La valeur seuil Cₘᵢₙ prédéterminée est avantageusement égale à 5×10¹⁹ at. cm⁻³, préférentiellement supérieure ou égale à 10²⁰ at. cm⁻³, plus préférentiellement supérieure ou égale à 10²¹ at. cm⁻³.

### Implantation ionique de l'étape b)

La technique d'implantation ionique par immersion plasma 20 est avantageusement exécutée lors de l'étape b) avec :
- une dose de premiers dopants 2 adaptée pour que le premier profil modifié P'₁ présente une zone avec des valeurs de concentrations supérieures ou égales à la valeur seuil Cₘᵢₙ prédéterminée à l'issue de l'étape d) ;
- une tension de polarisation du plasma 20 adaptée au traitement thermique de l'étape d) pour que le premier profil modifié P'₁ s'étende sur la première épaisseur e₁ à l'issue de l'étape d).

Plus précisément, la technique d'implantation ionique par immersion plasma 20 est exécutée lors de l'étape b) avec :
- une dose de premiers dopants 2 adaptée au budget thermique du traitement thermique de l'étape d) pour que le premier profil modifié P'₁ présente une zone avec des valeurs de concentrations supérieures ou égales à 5×10¹⁹ at. cm⁻³ à l'issue de l'étape d) ;
- une tension de polarisation du plasma 20 adaptée au budget thermique du traitement thermique de l'étape d) pour que le premier profil modifié P'₁ s'étende sur la première épaisseur e₁ à l'issue de l'étape d).

Le choix de la valeur de la dose de premiers dopants 2 et le choix de la valeur de la tension de polarisation du plasma 20 dépendent au premier ordre de la température du traitement thermique de l'étape d), et dépendent au second ordre de la durée du traitement thermique de l'étape d). A titre d'exemple, lesdites valeurs de la dose et de la tension de polarisation peuvent être testées à l'aide d'un simple plan d'expériences (DOE pour « *Design Of Experiments*» en langue anglaise) à la portée de l'homme du métier. Les valeurs de concentration du premier profil modifié P'₁ et la première épaisseur e₁ peuvent être mesurées à l'issue de l'étape d) par des techniques connues de l'homme du métier, par exemple par ECV *(*« *Electrochemical Capacitance Voltage»* en langue anglaise) ou par SIMS (« *Secondary Ion Mass Spectrometry*» en langue anglaise).

La dose de premiers dopants 2 est préférentiellement comprise entre 10¹⁴ at.cm⁻² et 10¹⁷ at.cm⁻². Lorsque les premiers dopants 2 sont de type n, les premiers dopants 2 sont avantageusement des atomes de phosphore ou des atomes d'arsenic. Lorsque les premiers dopants 2 sont de type p, les premiers dopants 2 sont avantageusement des atomes de bore.

La première épaisseur e₁ est avantageusement inférieure ou égale à 100 nm.

Lorsque la première surface 10 du substrat 1 prévu lors de l'étape a) est revêtue d'une couche de passivation 100, l'étape b) est avantageusement exécutée de sorte que les premiers dopants 2 sont implantés majoritairement dans la couche de passivation 100.

### Implantation ionique de l'étape c)

La technique d'implantation ionique par immersion plasma 30 est avantageusement exécutée lors de l'étape c) avec :
- une dose de seconds dopants 3 adaptée pour que le second profil modifié P'₂ présente une zone avec des valeurs de concentrations supérieures ou égales à la valeur seuil Cₘᵢₙ prédéterminée à l'issue de l'étape d) ;
- une tension de polarisation du plasma 30 adaptée au traitement thermique de l'étape d) pour que le second profil modifié P'₂ s'étende sur la seconde épaisseur e₂ à l'issue de l'étape d).

Plus précisément, la technique d'implantation ionique par immersion plasma 30 est exécutée lors de l'étape c) avec :
- une dose de seconds dopants 3 adaptée au budget thermique du traitement thermique de l'étape d) pour que le second profil modifié P'₂ présente une zone avec des valeurs de concentrations supérieures ou égales à 5×10¹⁹ at. cm⁻³ à l'issue de l'étape d) ;
- une tension de polarisation du plasma 30 adaptée au budget thermique du traitement thermique de l'étape d) pour que le second profil modifié P'₂ s'étende sur la seconde épaisseur e₂ à l'issue de l'étape d).

Le choix de la valeur de la dose de seconds dopants 3 et le choix de la valeur de la tension de polarisation du plasma 30 dépendent au premier ordre de la température du traitement thermique de l'étape d), et dépendent au second ordre de la durée du traitement thermique de l'étape d). A titre d'exemple, lesdites valeurs de la dose et de la tension de polarisation peuvent être testées à l'aide d'un simple plan d'expériences (DOE pour « *Design Of Experiments*» en langue anglaise) à la portée de l'homme du métier. Les valeurs de concentration du second profil modifié P'₂ et la seconde épaisseur e₂ peuvent être mesurées à l'issue de l'étape d) par des techniques connues de l'homme du métier, par exemple par ECV (« *Electrochemical Capacitance Voltage* » en langue anglaise) ou par SIMS (« *Secondary Ion Mass Spectrometry*» en langue anglaise).

La dose de seconds dopants 3 est préférentiellement comprise entre 10¹⁴ at.cm⁻² et 10¹⁷ at.cm⁻². Lorsque les seconds dopants 3 sont de type n, les seconds dopants 3 sont avantageusement des atomes de phosphore ou des atomes d'arsenic. Lorsque les seconds dopants 3 sont de type p, les seconds dopants 3 sont avantageusement des atomes de bore.

La seconde épaisseur e₂ est strictement supérieure à la première épaisseur e₁. La seconde épaisseur e₂ est préférentiellement inférieure ou égale à 500 nm, de préférence inférieure ou égale à 200 nm.

Lorsque la première surface 10 du substrat 1 prévu lors de l'étape a) est revêtue d'une couche de passivation 100, l'étape c) est avantageusement exécutée de sorte que les seconds dopants 3 sont majoritairement implantés dans la couche de passivation 100.

L'étape c) ne succède pas nécessairement à l'étape b). Les étapes b) et c) peuvent être interverties.

### Traitement thermique de l'étape d)

Le traitement thermique est avantageusement appliqué lors de l'étape d) sous une atmosphère oxydante ou sous une atmosphère comportant majoritairement du H₂. Toutefois, le traitement thermique de l'étape d) peut également être appliqué sous une atmosphère inerte (e.g. diazote, argon).

Le traitement thermique appliqué lors de l'étape d) est avantageusement un recuit thermique comportant un cycle de chauffage comprenant :
- une première phase de montée graduelle d'une température de chauffage jusqu'à atteindre une valeur plateau ;
- une deuxième phase où la température de chauffage conserve la valeur plateau ;
- une troisième phase de refroidissement.

La valeur plateau est avantageusement choisie en fonction de la limite de solubilité des premiers et seconds dopants 2, 3 dans le silicium du substrat 1 de manière à obtenir des concentrations de premiers et seconds dopants 2, 3 suffisamment élevées de part et d'autre de la jonction. Les premiers et seconds dopants 2, 3 sont avantageusement choisis en fonction de leurs limites de solubilité dans le silicium du substrat 1 afin d'obtenir un mécanisme de compensation de dopage en surface pour les premiers dopants 2.

Le recuit thermique appliqué lors de l'étape d) est avantageusement un recuit thermique rapide, la deuxième phase présentant une durée inférieure ou égale à 300 secondes, de préférence inférieure ou égale à 30 secondes.

Le recuit thermique est avantageusement appliqué lors de l'étape d) selon un budget thermique adapté pour activer électriquement les premiers et seconds dopants 2, 3. A titre d'exemple non limitatif, une valeur plateau de 1050°C et une durée de 1 seconde pour la deuxième phase permettent d'activer électriquement des atomes de bore et des atomes de phosphore ou d'arsenic. Par « budget thermique », on entend le choix d'une valeur de température de recuit (i.e. la valeur plateau) et le choix d'une valeur de durée de recuit (i.e. la durée de la deuxième phase).

Comme illustré à la figure 1d, à l'issue de l'étape d) et de la compensation des premier et second profils modifiés P'₁, P'₂, on obtient :
- une première zone 200 du substrat 1 -dite jonction courte ou jonction finemajoritairement dopée du premier type de conductivité par les premiers dopants 2 (porteurs libres).
- une seconde zone 300 du substrat 1 -dite jonction longue ou jonction profondemajoritairement dopée du second type de conductivité par les seconds dopants 3 (porteurs libres).

Il est à noter qu'il n'est pas nécessaire que l'absolue totalité de la première zone 200 du substrat 1 présente une différence de concentration entre les premiers dopants 2 et les seconds dopants 3 supérieure ou égale à la valeur seuil Cₘᵢₙ prédéterminée. De la même façon, il n'est pas nécessaire que l'absolue totalité de la seconde zone 300 du substrat 1 présente une différence de concentration entre les seconds dopants 3 et les premiers dopants 2 supérieure ou égale à la valeur seuil Cₘᵢₙ prédéterminée.

### Exemple particulier de réalisation

Le substrat 1 prévu lors de l'étape a) est réalisé en silicium monocristallin, dopé de type p. Les premiers dopants 2 implantés lors de l'étape b) sont des atomes de bore (type p), avec une dose de 1,85 × 10¹⁵ at.cm⁻². Les seconds dopants 3 implantés lors de l'étape c) sont des atomes de phosphore (type n), avec une dose de 1,5 × 10¹⁶ at.cm⁻². Le traitement thermique appliqué lors de l'étape d) est un recuit thermique rapide, avec :
- une valeur plateau de la température de chauffage égale à 1050°C,
- une durée de la deuxième phase égale à 1 seconde.

## Revendications

1. Procédé de fabrication d'une jonction à effet tunnel inter-bandes, comportant les étapes :
a) prévoir un substrat (1), réalisé en silicium cristallin, et présentant une première surface (10) ;
b) implanter des premiers dopants (2), d'un premier type de conductivité, dans le substrat (1) à travers la première surface (10) ; l'étape b) étant exécutée par une technique d'implantation ionique par immersion plasma (20), de manière à obtenir un premier profil (P₁) de concentration des premiers dopants (2) dans le substrat (1) ;
c) implanter des seconds dopants (3), d'un second type de conductivité différent du premier type de conductivité, dans le substrat (1) à travers la première surface (10) ; l'étape c) étant exécutée par une technique d'implantation ionique par immersion plasma (30), de manière à obtenir un second profil (P₂) de concentration des seconds dopants (3) dans le substrat (1) ;
d) appliquer un traitement thermique au substrat (1), selon un budget thermique ;
les implantations des étapes b) et c) et le budget thermique du traitement thermique de l'étape d) étant adaptés pour que le premier profil (P₁) soit modifié et s'étende sur une première épaisseur (e₁), et que le second profil (P₂) soit modifié et s'étende sur une seconde épaisseur (e₂) strictement supérieure à la première épaisseur (e₁) ;
le budget thermique du traitement thermique de l'étape d) étant adapté pour que :
- les premiers et seconds dopants (2, 3) soient activés électriquement ;
- les seconds dopants (3) possèdent une vitesse de diffusion dans le substrat (1) supérieure à celle des premiers dopants (2), jusqu'à obtenir :
une première zone (200) du substrat (1) présentant une différence de concentration entre les premiers dopants (2) et les seconds dopants (3) supérieure ou égale à 5×10¹⁹ at. cm⁻³,
une seconde zone (300) du substrat (1) présentant une différence de concentration entre les seconds dopants (3) et les premiers dopants (2) supérieure ou égale à 5×10¹⁹ at. cm⁻³.

2. Procédé selon la revendication 1, dans lequel la seconde épaisseur (e₂) est inférieure ou égale à 500 nm, de préférence inférieure ou égale à 200 nm.

3. Procédé selon la revendication 1 ou 2, dans lequel la technique d'implantation ionique par immersion plasma (20) est exécutée lors de l'étape b) avec :
- une dose de premiers dopants (2) adaptée au budget thermique du traitement thermique de l'étape d) pour que le premier profil modifié (P'₁) présente une zone avec des valeurs de concentrations supérieures ou égales à 5×10¹⁹ at. cm⁻³ à l'issue de l'étape d) ;
- une tension de polarisation du plasma (20) adaptée au budget thermique du traitement thermique de l'étape d) pour que le premier profil modifié (P'₁) s'étende sur la première épaisseur (e₁) à l'issue de l'étape d).

4. Procédé selon l'une des revendications 1 à 3, dans lequel la technique d'implantation ionique par immersion plasma (30) est exécutée lors de l'étape c) avec :
- une dose de seconds dopants (3) adaptée au budget thermique du traitement thermique de l'étape d) pour que le second profil modifié (P'₂) présente une zone avec des valeurs de concentrations supérieures ou égales à 5×10¹⁹ at. cm⁻³ à l'issue de l'étape d) ;
- une tension de polarisation du plasma (30) adaptée au budget thermique du traitement thermique de l'étape d) pour que le second profil modifié (P'₂) s'étende sur la seconde épaisseur (e₂) à l'issue de l'étape d).

5. Procédé selon l'une des revendications 1 à 4, dans lequel le traitement thermique est appliqué lors de l'étape d) sous une atmosphère oxydante ou sous une atmosphère comportant majoritairement du H₂.

6. Procédé selon l'une des revendications 1 à 5, dans lequel le traitement thermique appliqué lors de l'étape d) est un recuit thermique comportant un cycle de chauffage comprenant :
- une première phase de montée graduelle d'une température de chauffage jusqu'à atteindre une valeur plateau ;
- une deuxième phase où la température de chauffage conserve la valeur plateau ;
- une troisième phase de refroidissement.

7. Procédé selon la revendication 6, dans lequel le recuit thermique appliqué lors de l'étape d) est un recuit thermique rapide, la deuxième phase présentant une durée inférieure ou égale à 300 secondes, de préférence inférieure ou égale à 30 secondes.

8. Procédé selon l'une des revendications 1 à 7, dans lequel la première surface (10) du substrat (1) prévu lors de l'étape a) est revêtue d'une couche de passivation (100) ; les étapes b) et c) étant exécutées de sorte que les premiers et seconds dopants (2, 3) sont implantés à travers la couche de passivation (100).

9. Procédé selon l'une des revendications 1 à 8, dans lequel le substrat (1) prévu lors de l'étape a) est dopé du premier type de conductivité.

## Patentansprüche

1. Verfahren zur Herstellung eines Übergangs mit Interband-Tunneleffekt, umfassend die Schritte:
a) Vorsehen eines Substrats (1), das aus kristallinem Silicium ausgeführt ist und eine erste Oberfläche (10) aufweist;
b) Implantieren der ersten Dotierungsmittel (2) eines ersten Leitfähigkeitstyps in das Substrat (1) durch die erste Oberfläche (10) hindurch; wobei der Schritt b) mit einer Plasma-Immersions-Ionenimplantationstechnik (20) durchgeführt wird, so dass ein erstes Konzentrationsprofil (P₁) der ersten Dotierungsmittel (2) in dem Substrat (1) erhalten wird;
c) Implantieren der zweiten Dotierungsmittel (3) eines zweiten Leitfähigkeitstyps, der von dem ersten Leitfähigkeitstyp verschieden ist, in das Substrat (1) durch die erste Oberfläche (10) hindurch; wobei der Schritt c) mit einer Plasma-Immersionslonenimplantationstechnik (30) durchgeführt wird, so dass ein zweites Konzentrationsprofil (P₂) der zweiten Dotierungsmittel (3) in dem Substrat (1) erhalten wird;
d) Anwenden einer Wärmebehandlung auf das Substrat (1) gemäß einem Wärmebudget;
wobei die Implantationen der Schritte b) und c) und das Wärmebudget der Wärmebehandlung des Schritts d) angepasst werden, damit das erste Profil (P₁) geändert wird und sich über eine erste Dicke (e₁) erstreckt und das zweite Profil (P₂) geändert wird und sich über eine zweite Dicke (e₂) erstreckt, die strikt größer als die erste Dicke (e₁) ist;
wobei das Wärmebudget der Wärmebehandlung des Schritts d) angepasst wird, damit:
- die ersten und zweiten Dotierungsmittel (2, 3) elektrisch aktiviert werden;
- die zweiten Dotierungsmittel (3) eine Diffusionsgeschwindigkeit im Substrat (1) besitzen, die höher als die der ersten Dotierungsmittel (2) ist, bis erhalten wird:
eine erste Zone (200) des Substrats (1), die einen Konzentrationsunterschied zwischen den ersten Dotierungsmitteln (2) und den zweiten Dotierungsmitteln (3) größer oder gleich 5×10¹⁹ at.cm⁻³ aufweist,
eine zweite Zone (300) des Substrats (1), die einen Konzentrationsunterschied zwischen den zweiten Dotierungsmitteln (3) und den ersten Dotierungsmitteln (2) größer oder gleich 5×10¹⁹ at.cm⁻³ aufweist.

2. Verfahren nach Anspruch 1, bei dem die zweite Dicke (e₂) kleiner oder gleich 500 nm, bevorzugt kleiner oder gleich 200 nm ist.

3. Verfahren nach Anspruch 1 oder 2, bei dem die Plasma-Immersionslonenimplantationstechnik (20) während des Schritts b) durchgeführt wird mit:
- einer Dosis erster Dotierungsmittel (2), die an das Wärmebudget der Wärmebehandlung des Schritts d) angepasst ist, damit das geänderte erste Profil (P'₁) nach dem Schritt d) eine Zone mit Konzentrationswerten größer oder gleich 5×10¹⁹ at.cm⁻³ aufweist;
- einer Polarisationsspannung des Plasmas (20), die an das Wärmebudget der Wärmebehandlung des Schritts d) angepasst ist, damit sich das erste geänderte Profil (P'₁) nach dem Schritt d) über die erste Dicke (e₁) erstreckt.

4. Verfahren nach einem der Ansprüche 1 bis 3, bei dem die Plasma-Immersionslonenimplantationstechnik (30) während des Schritts c) durchgeführt wird mit:
- einer Dosis zweiter Dotierungsmittel (3), die an das Wärmebudget der Wärmebehandlung des Schritts d) angepasst ist, damit das geänderte zweite Profil (P'₂) nach dem Schritt d) eine Zone mit Konzentrationswerten größer oder gleich 5×10¹⁹ at.cm⁻³ aufweist;
- einer Polarisationsspannung des Plasmas (30), die an das Wärmebudget der Wärmebehandlung des Schritts d) angepasst ist, damit sich das geänderte zweite Profil (P'₂) nach dem Schritt d) über die zweite Dicke (e₂) erstreckt.

5. Verfahren nach einem der Ansprüche 1 bis 4, bei dem die Wärmebehandlung während des Schritts d) unter einer oxidierenden Atmosphäre oder unter einer mehrheitlich H₂ beinhaltenden Atmosphäre angewandt wird.

6. Verfahren nach einem der Ansprüche 1 bis 5, bei dem die während des Schritts d) angewandte thermische Behandlung ein thermisches Glühen ist, das einen Erwärmungszyklus beinhaltet, der umfasst:
- eine erste Phase des stufenweisen Anstiegs einer Erwärmungstemperatur, bis ein Plateauwert erreicht ist;
- eine zweite Phase, in der die Erwärmungstemperatur den Plateauwert beibehält;
- eine dritte Abkühlungsphase.

7. Verfahren nach Anspruch 6, bei dem das während des Schritts d) angewandte thermische Glühen ein schnelles thermisches Glühen ist, wobei die zweite Phase eine Dauer kleiner oder gleich 300 Sekunden, bevorzugt kleiner oder gleich 30 Sekunden aufweist.

8. Verfahren nach einem der Ansprüche 1 bis 7, bei dem die erste Oberfläche (10) des Substrats (1), das während des Schritts a) vorgesehen ist, mit einer Passivierungsschicht (100) überzogen ist; wobei die Schritte b) und c) so durchgeführt werden, dass die ersten und zweiten Dotierungsmittel (2, 3) durch die Passivierungsschicht (100) hindurch implantiert werden.

9. Verfahren nach einem der Ansprüche 1 bis 8, bei dem das während des Schritts a) vorgesehene Substrat (1) mit dem ersten Leitfähigkeitstyp dotiert ist.

## Claims

1. Method for fabricating an interband tunnel junction, comprising the steps:
a) providing a substrate (1), made of crystalline silicon, and having a first surface (10);
b) implanting first dopants (2), of a first conductivity type, in the substrate (1) through the first surface (10); step b) being carried out by a plasma (20) immersion ion implantation technique, so as to obtain a first concentration profile (Pi) of the first dopants (2) in the substrate (1);
c) implanting seconds dopants (3), of a second conductivity type different from the first conductivity type, in the substrate (1) through the first surface (10); step c) being carried out by a plasma (30) immersion ion implantation technique, so as to obtain a second concentration profile (P₂) of the second dopants (3) in the substrate (1);
d) applying a heat treatment to the substrate (1), according to thermal budget;
the implantations of steps b) and c) and the thermal budget of the heat treatment of step d) being adapted so that the first profile (P₁) is modified and extends over a first thickness (e₁), and so that the second profile (P₂) is modified and extends over a second thickness (e₂) strictly greater than the first thickness (e₁);
the thermal budget of the heat treatment of step d) being adapted so that:
- the first and second dopants (2, 3) are electrically activated;
- the second dopants (3) have a rate of diffusion into the substrate (1) greater than that of the first dopants (2), until the following are obtained:
a first zone (200) of the substrate (1) having a difference in concentration between the first dopants (2) and the second dopants (3) that is greater than or equal to 5×10¹⁹ at.cm⁻³,
a second zone (300) of the substrate (1) having a difference in concentration between the second dopants (3) and the first dopants (2) that is greater than or equal to 5×10¹⁹ at.cm⁻³.

2. Method according to Claim 1, in which the second thickness (e₂) is less than or equal to 500 nm, preferably less than or equal to 200 nm.

3. Method according to Claim 1 or 2, in which the plasma (20) immersion ion implantation technique is carried out during step b) with:
- a dose of first dopants (2) adapted to the thermal budget of the heat treatment of step d) so that the modified first profile (P'₁) has a zone with concentration values greater than or equal to 5×10¹⁹ at.cm⁻³ at the end of step d);
- a bias voltage of the plasma (20) adapted to the thermal budget of the heat treatment of step d) so that the modified first profile (P'₁) extends over the first thickness (e₁) at the end of step d).

4. Method according to one of Claims 1 to 3, in which the plasma (30) immersion ion implantation technique is carried out during step c) with:
- a dose of second dopants (3) adapted to the thermal budget of the heat treatment of step d) so that the modified second profile (P'₂) has a zone with concentration values greater than or equal to 5×10¹⁹ at.cm⁻³ at the end of step d);
- a bias voltage of the plasma (30) adapted to the thermal budget of the heat treatment of step d) so that the modified second profile (P'₂) extends over the second thickness (e₂) at the end of step d).

5. Method according to one of Claims 1 to 4, in which the heat treatment is applied during step d) under an oxidizing atmosphere or under an atmosphere comprising predominantly H₂.

6. Method according to one of Claims 1 to 5, in which the heat treatment applied during step d) is a thermal annealing including a heating cycle comprising:
- a first phase of gradual increase in heating temperature until a plateau value is reached;
- a second phase where the heating temperature retains the plateau value;
- a third phase of cooling.

7. Method according to Claim 6, in which the thermal annealing applied during step d) is a rapid thermal annealing, the second phase having a duration of less than or equal to 300 seconds, preferably less than or equal to 30 seconds.

8. Method according to one of Claims 1 to 7, in which the first surface (10) of the substrate (1) provided during step a) is coated with a passivation layer (100); steps b) and c) being carried out so that the first and second dopants (2, 3) are implanted through the passivation layer (100).

9. Method according to one of Claims 1 to 8, in which the substrate (1) provided during step a) is doped with the first type of conductivity.
